(19) **Europäisches Patentamt / European Patent Office / Office européen des brevets**

(11) **EP 1 724 923 B1**

(12) **EUROPEAN PATENT SPECIFICATION**

(45) Date of publication and mention
of the grant of the patent:
**06.02.2008 Bulletin 2008/06**

(51) Int Cl.:
*H03K 5/05* (2006.01)  *H03K 7/08* (2006.01)
*H03M 3/02* (2006.01)

(21) Application number: **05104301.6**

(22) Date of filing: **20.05.2005**

(54) **Signal generation**

Signal Generator

Générateur de signaux

(84) Designated Contracting States:
**DE FR GB**

(43) Date of publication of application:
**22.11.2006 Bulletin 2006/47**

(73) Proprietor: **Agilent Technologies, Inc.**
**Santa Clara, CA 95051 (US)**

(72) Inventors:
• **Moll, Joachim**
  **71083, Herrenberg (DE)**

• **Muecke, Martin**
  **Stuttgart, 70199 (DE)**

(74) Representative: **Barth, Daniel Mathias et al**
**Agilent Technologies Deutschland GmbH**
**Patentabteilung**
**Herrenberger Strasse 130**
**71034 Böblingen (DE)**

(56) References cited:
**EP-A- 0 875 994**       **US-A- 4 700 367**
**US-A- 4 805 199**

## Description

BACKGROUND ART

The present invention relates to digital signal generation.

In arbitrary signal generation, a pulse can be understood as a sequence of individual subsequent digital signals. The temporal behavior of pulse signals can be described by different parameters. The pulse period defines the period of time between two subsequent pulse signals. Further parameters define the delay and the pulse width of the pulse signals.

An example of a Pulse Generator is given in document EP 0 875 994.

Digital pulse pattern generators using analog circuitry are known from prior art. For generating a pulse pattern according to the above-defined parameters, individual oscillators circuits might be provided. Examples of such pulse generators are the Agilent 81100 Family of Pulse Pattern Generators of the applicant Agilent Technologies.

DISCLOSURE OF THE INVENTION

It is an object of the present invention to provide an improved signal generator.

This object is achieved by the present invention as defined by the independent claims. Preferred embodiments are subject matter of the dependent claims.

A generator for generating a sequence of digital values according to an embodiment of the present invention comprises a counter adapted for providing a counter position dependent on a reference clock. More particular the counter is adapted for providing its position with each reference clock cycle. The digital edge generator according to the embodiment of the present invention receives a start signal, an increment signal, further referred to as an increment word and an offset signal, further referred to as an offset word respectively. The offset word corresponds to a delay of the edge's starting point in time. The digital edge generator is adapted for setting the counter's position to a start position derived from a multiplication of the offset word and the increment word upon detection of the start signal. It also sets the counter's position to a new position derived from the increment word with each clock cycle.

The setting of a start position upon detection of the start signal and dependant on the offset word allows more flexible timing setting. More particular, the offset word takes into account that the rising or falling edge might start between to subsequent reference clock cycles. An additional and undesired start delay until the next reference clock cycle, resulting in a distortion of the edge will not occur. It will be noted that the slope of the edge is given by the increment word, which includes be a positive value in case of a rising edge or a negative value in case of a falling edge. In an embodiment the start position is derived from the offset word and the increment word. In this embodiment the edge generator is adapted for generating a sequence of digital signals and more particularly a sequence of digital values, characterizing a rising or falling edge. Analog circuitry and calibration thereof, for example of capacitors is not necessary.

In another embodiment the counter comprises a register and a summing element, which is connected to the first input terminal of the edge generator and an output of the register. The register's value, corresponding to the counter's value is fed back, summed up with the increment word and stored in the register as a new value. With each reference clock cycle the register increases or decreases its value. In another embodiment, a switch is coupled between the summing element and the input of the register. The switch is also coupled to the second input terminal for the offset word for storing the start position in the register.

In a further embodiment, the output is coupled to a memory lookup table, which is adapted for generating digital value derived from the output of the counter. A memory look-up table is advantageous, if additional distortion shall be used or spurs suppressed. As an alternative the output of the edge generator is couple to an digital-analog converter. In still another embodiment, the output of the counter is coupled to a switch. A constant digital value is fed in at the second input of the switch. The switch switches its position upon detection of a start signal and dependant on the counter's position.

A controlled pulse pattern generator according to an embodiment of the present invention uses digital frequency synthesis. For the generation process the embodiment implements a flexible and individual setting of timing parameters defining a pulse, including the pulse period, the pulse width, the rising and falling time. All timing parameters are derived from one stable high-speed clock including the digital generation of the pulse slopes. Henceforth, the rising and falling time can be chosen independently from each other using the digital edge generator according to the present invention. No complex calibration of analog circuitry becomes necessary. Particularly, the controlled pulse pattern generator comprises a period counter adapted for the generation of a start signal and a first offset word. The start signal and the first offset word are derived from a high-speed stable reference clock and a pre-given pulse period. Output terminals of the period counter are coupled to a first digital edge generator. The first digital edge generator is adapted for the generation of a rising edge in respect to the start signal and the first offset word. A further width counter is also coupled to the period counter. It is adapted for the generation of a stop signal and a second offset word, which are derived from a pre-given pulse width, the reference clock, and the first offset word in respect to the start signal. Finally, a second digital edge generator, coupled to the width counter, is adapted for the generation of a falling edge in respect to the stop signal and the second offset word.

The period counter, as well as the width counter, takes a possible phase offset word in respect to the reference clock, the pulse period and the pulse width respectively into account. Hence a phase offset word will be generated, if the pulse period and the pulse width respectively include a non-integer multiple of the reference clock cycle, the phase offset word corresponding to a delay between subsequent reference clock cycles. The embodiment according to the present invention is adapted for setting of the pulse period and the pulse width independently from the reference clock and generating a corresponding pulse pattern. Additionally the edge generators are independent from each other, allowing any setting of slopes for the generation. The pulse pattern generator according to an embodiment of the present invention uses only one stable reference clock. A change of pulse timing parameters is fast, because oscillators do not have to be tuned.

In an embodiment of the invention, a switching device is provided. The switching device is coupled with its inputs to the respective outputs of the respective first and second edge generators. It is being adapted for switching one of its inputs to its output in respect to the start signal and the stop signal. More particularly, the switching unit is being adapted for coupling the output of the first edge generator to its output in case a start signal is provided and to couple the output of the second edge generator to its output in case a stop signal is provided. Due to the generation of the start and the stop signal, the output of the corresponding edge generators are then fed through the output of the controlled pulse pattern generator by the switching unit in correspondence to the start and the stop signal. Preferable the output of the switching unit is coupled to a Digital-Analog converter.

In a further embodiment, the period counter comprises a first register, an overflow detection device coupled to the first register, and being adapted for detecting an overflow of the first register. The period counter is adapted for the generation of the start signal upon such detection of an overflow. Additionally, the first offset word is derived from an overflow value of the first register and is generated upon overflow detection as well. In a preferred embodiment, the pulse period is derived from a length of the first register and an increment word. Particularly, the register's value is increased by the increment word with each reference clock cycle until the length of the first register is reached. With the next increment, the overflow detection device will detect an overflow of the register and also derive the overflow value of the register. The overflow value corresponds to a delay and includes a value smaller than the increment word.

In a further embodiment, the width counter comprises a second register, an overflow detection device coupled to the second register and adapted for detecting an overflow. The width counter is adapted for the generation of a stop signal and the second offset word, upon detection of the start signal. The second offset word is derived from an overflow value of the second register. In a preferred embodiment, the pulse width is derived at least from the length of the second register and an increment word.

Because a possible phase offset between the stable reference clock and the pulse period have to be taken into account, the width counter comprises means for saving a start position in the second register derived from the first offset word.

In an embodiment of the invention, a first and second register comprises a register length of at least 48 bits and, more particularly, a register length of 64 bits. Also, it is possible to use other register lengths as well as different register length for the first and second register of the period counter and the width counter. For example, the first register might include a length of 32 bits, 36 bits or 72 bits. The register length together with the stable reference clock cycle define the maximum length of the pulse period and the pulse width, respectively.

It might become necessary that the slopes of the pulses generated by the inventive pulse pattern generator have to be distorted in order to suppress or prevent spurs in the signal. Therefore, the pulse pattern generator according to an embodiment of the invention comprises a memory table, coupled to the outputs of the first and second edge generators. The memory table comprises output values and is adapted for generating digital values derived from the digital output of the first and second edge generator. Preferable the memory table is adapted as a memory lookup table, which can be used to smooth or change the output values generated by the edge generators. Scaling or distorting the output values is possible.

In a further embodiment, the outputs of the first and second edge generators are coupled to an input of a digital-analog converter for digital-analog conversion. In an embodiment, the pulse pattern generator comprises a digital-analog converter, coupled to the output of the memory lookup table. The output of the pulse pattern generator according to this embodiment of the present invention is an analog pulse pattern, digitally generated or alternately fully digitally generated.

As mentioned above, a pulse pattern can be defined by a pulse period, a pulse width and a pulse delay. To generate a pulse pattern in a more flexible way, the method according to the present invention uses direct frequency synthesis. It provides a stable reference clock in a first step. Also the pulse period and the pulse width have to be defined. The signal is generated by generating a rising edge in respect to a start signal and a first offset word. The start signal and the first offset word is derived from the pulse period and the stable reference clock. The first offset word takes into account that the pulse period might be a non-integer multiple of the reference clock cycle. It is used to correct any delay of subsequent generated pulses. Furthermore it corrects edge generation by setting a start position, when the rising edge is digitally generated.

The rising edge is then outputted. Furthermore, a signal having a falling edge is generated in respect to a stop signal and a second offset value. The stop signal and the second offset word are derived from the pulse width, the stable reference clock, the start signal, and the first offset word. The second offset word takes into account that the pulse width might be a non-integer multiple of the reference clock cycle. The falling edge is then outputted.

The method according to an embodiment of the present invention might be used in a fully digital synthesized generator having a frequency stable reference clock. In an embodiment, the step of generating a signal having a rising edge comprises also incrementing a counter by an increment word. The increment word corresponds to the pulse period. The generation of the start signal occurs upon detecting the counter's overflow. The first offset word is derived from an overflow value of the counter. The offset word corresponds to a time delay between the start of the edge and the reference clock cycle. Preferable, the rising edge counter is set to a start position derived from the first offset word derived before. The edge counter is then incremented by an increment word, corresponding to the rising edge slope of the pulse signal to be generated. The positions of the rising edge counter are then output in respect to the stable reference clock. In the same manner, a signal having a falling edge is generated.

In an embodiment of the present invention, the method for generating a pulse might comprise the steps of generating a signal having a rising edge in respect to a start signal and a first offset word, the start signal and the first offset word derived from a pulse period of the pulse to be generated and a stable reference clock. The edge is output. Then a signal having a falling edge in respect to a stop signal and a second offset word is generated, wherein the stop signal and the second offset word is derived from a pulse width, the stable reference clock, the start signal and the first offset word. The signal having a falling edge is output.

In a further embodiment of the invention a stable reference clock is provided and a signal representing the pulse period as well as a signal representing the pulse width is received. Receiving both signals allow the setting of the parameters independently from each other. In a further embodiment of the invention the pulse signal is generated by incrementing a counter by an incrementing signal or word respectively, wherein the incrementing word corresponds to the pulse width. Upon detection of a counter's overflow, a start signal and a first offset word, derived from the overflow value is generated. The start signal and the phase offset word are used for the generation of the rising edge.

In yet another embodiment of the invention generating the rising edge comprises the step of setting a rising edge counter to a start position, derived from the first offset word. The rising edge slope is defined by a rising increment signal or word, incrementing the rising edge counter each reference clock cycle and outputting the rising edge counter with each reference clock cycle.

It may be noted that the pulse width can be derived from a further word, corresponding to the pulse width. The word increments a width counter, the width counter set in an embodiment to a start value derived from the first offset signal or word respectively. The width counter is incremented by the word corresponding to the pulse width each reference clock cycle. Upon detection of an overflow of the width counter, a stop signal is generated and an overflow value of the width counter is derived, defining a second offset signal or second offset word. By using the stop signal and the second offset word a falling edge is generated in the same way as the generation of the rising edge. Of course, the falling edge counter is now decrement with each reference clock cycle.

The various embodiments of the method of the present invention provide a fast and flexible method to produce a sequence of digital signals, corresponding to a digital pulse. The digital pulse can be easily converted into an analog pulse. The different words and counters allow an independent setting of timing parameters of the pulse. More over all timing parameters take into account that they might be a non-integer multiply of the reference clock cycle by using the offset signals.

The inventive method is not limited to hardware components like application-specific circuits, field programming gate arrays, digital signal processors, or microprocessors. Also, a software program or product stored in a data carrier can be adapted for executing the method when running on a data processing system. This allows the flexible generation of pulse pattern signals completely by software.

BRIEF DESCRIPTION OF DRAWINGS

Other object and many advantages of the present invention will be readily appreciated and become better understood by reference to the following description taken with the accompanying drawings, in which

Figure 1 shows first embodiment of a fully digitally controlled pulse pattern generator according of the present invention,

Figure 2 shows a second embodiment of the fully digitally controlled pulse pattern generator,

Figure 3 shows an embodiment of a digital rising edge generator according to the present invention,

Figure 3A shows another embodiment of a digital edge generator according to the present invention,

Figure 4 shows an embodiment of a digital falling edge generator according to the present invention,

Figure 5 shows an embodiment of a period counter device according to the present invention,

Figure 6 shows an embodiment of a width counter device according to the present invention,

Figure 7 shows a clock-value diagram for the rising edge generator according to Figure 3 or Figure 3A,

Figure 8 shows a clock-value diagram of the falling edge generator according to Figure 4,

Figure 9A shows a diagram of the register value versus time,

Figure 9B shows a time-pulse diagram corresponding to Figure 9A,

Figure 10 shows a diagram of an embodiment of the inventive method,

Figure 11 shows an example of direct digital frequency synthesis,

Figure 12 shows an embodiment of the trigger calculation unit and the preceding circuitry, and

Fig. 13 shows a diagram of an embodiment of a method according to the invention.

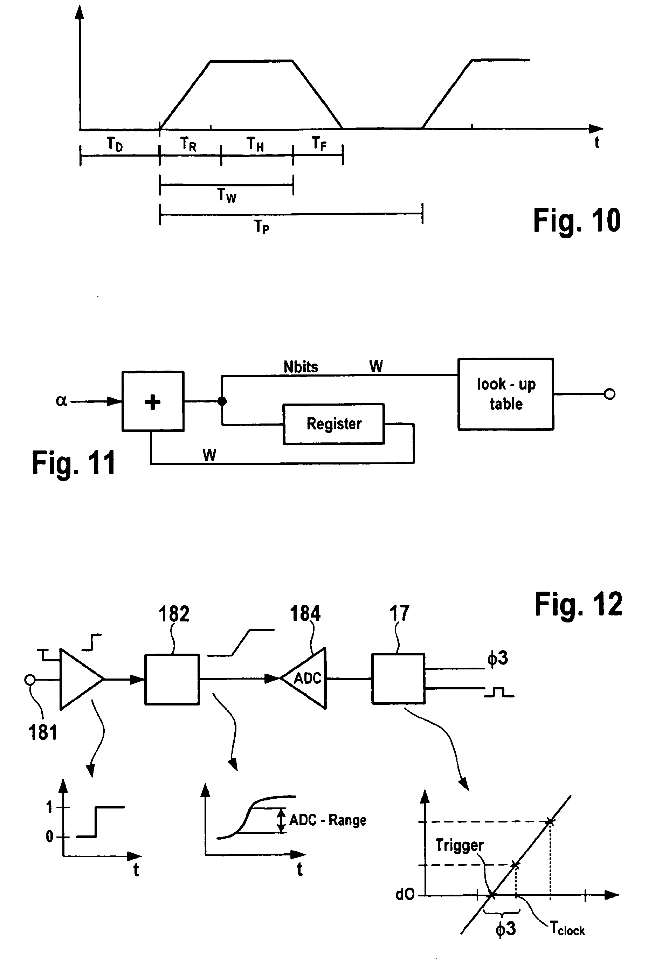

Figure 10 shoes an exemplary pulse with a rising edge having a rising time TR and a falling edge having a falling time $T_F$. The time $T_H$ between the end of the rising edge and the start of the falling edge is considered as the high state of the pulse. The sum of the rising time $T_R$ and the high state of the pulse will be defined as the pulse width $T_W$. The total time period Tp between two subsequent pulses is given by pulse width $T_W$, the falling time $T_F$, and the delay time $T_D$, which can also be seen as the low state of the pulse.

Conventional methods using phase accumulation techniques are shown in Figure 11 using direct digital frequency synthesis. An output control word W is continuously increased in constant increments of a. The control word W is output by the register R, which represents a counter incrementing its internal position. The output control word W is used as an argument to a lookup table or an analog-digital converter. Since frequency is defined as being the deviate of the phase, the output of the digital-analog converter is an analog signal of a constant frequency determined by the increment value a.

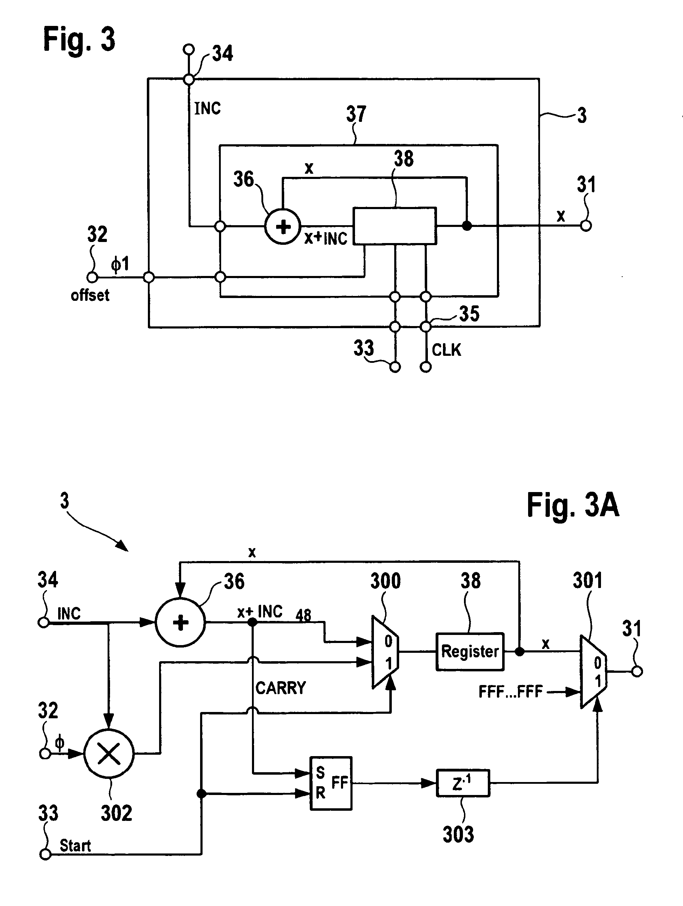

Figure 3 shows an embodiment of a digital rising edge generator according to the present invention. A corresponding falling edge generator will be explained below in more detail.

The digital rising edge generator comprises a counter 37 having a register 38 of a specific length, for example 48 bits. Other register lengths like 32, 36, 54 or 24 can also be used. The counter 37 is similar to a direct digital frequency synthesis loop according to Figure 11. The output X of the register 38 corresponds to the counter's position. The output X is provided at a terminal 31 but also fed back to a summary element 36, which adds the output X to an increment word INC. This increment word defines the slope of the rising edge. The sum X+INC replaces in the old value the register 38. The rising edge generator 3 comprises an input terminal 34 for the increment word INC. It further comprises an input terminal 33 for the start signal provided by the period counter device 2 and a terminal 35 for the reference clock CLK. The input terminals 33 and 35 are coupled to the register 38 of the counter 37. In operation the register output its value with each clock cycle CLK. In addition the register's value is increase by the increment word INC with each reference clock cycle CLK. Additionally, the register 38 is coupled to a terminal 32 for the first offset word φ1. The offset word φ1 is stored as a start value in the register 38, thereby corresponding to a start position of the counter 37.

Another embodiment of a rising edge generator can be seen in Figure 3a. Similar circuit block have the same reference signs. The rising edge generator according to the embodiment of Figure 3a comprises also a register 38, whose input is connected to a first switch 300. A first input of the switch 300 is connected to the output of the summing element 36, while a second output is coupled to the second input terminal 32 via a multiplier 302. The switch is used for setting the register's value to a starting position, as it will be explained later. The output of the register is connected to the summing element 36 and also to a first input of a second switch 301. The output of the switch 301 corresponds to the terminal 31. A second input of the switch is adapted for feeding a constant digital value, which is in this non-limiting example for a rising edge generator a digital value corresponding to the maximum of the counter and the rising edge generator. It will be noted that in case of a falling edge generator, the digital value fed into the second input might be a minimum of the counter, for example 0.

The switch 300 is connected to the terminal 33 and controlled directly by the start signal. The second switch 301 is coupled to a delay element 303. Furthermore a flip-flop circuit is provided having a data input terminal connected to the output of the summing element 36 and a reset terminal, connected to terminal 33.

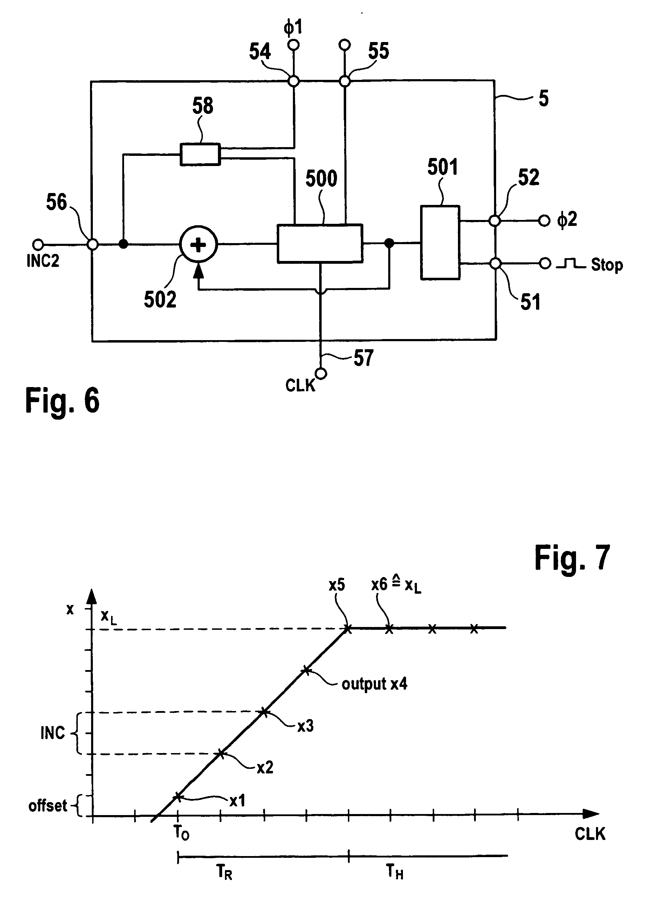

An example of an output X of the rising edge generator 3 according to Figure 3a can be seen in Figure 7. It shows the output X over the reference clock cycles. As one can see, the starting point $T_S$ of the rising edge is not at the time $T_0$, corresponding to a reference clock cycle, but between the time $T_0$ and the preceding reference clock cycle. It is clear that delaying the starting point $T_S$ until the next reference clock cycle results in a delay rising edge as well. Hence the start position of the rising edge generator at the time T0 has to be shifted to X1. The value X1 corresponds to the offset. It is determined by the offset word φ1 multiplied by the increment word INC, wherein the offset word φ1 defines a fraction between 0 and 1. In the particular example the offset word φ1 will be 0.5.

When a start signal is present at terminal 33 according to Figure 3a, the offset derived from φ1 and INC will be stored in the register as a starting position. With the next reference clock cycle the offset is output as first value X1. The register's value is then incremented by the increment word INC. The increment word INC together with the register length of the register 38 determines the rising time $T_R$ with each reference clock cycle, the current register's value is output for further processing. When the register's value reaches the register length $X_L$, the switch 301 will be switched to its second input, thereby outputting the maximum value. This will be the so-called high state of the pulse. In this non-limiting example, the output of the rising edge generator will be the subsequent values of $X_1$ to $X_5$ for the rising edge and then $X_6$ representing high state of the pulse.

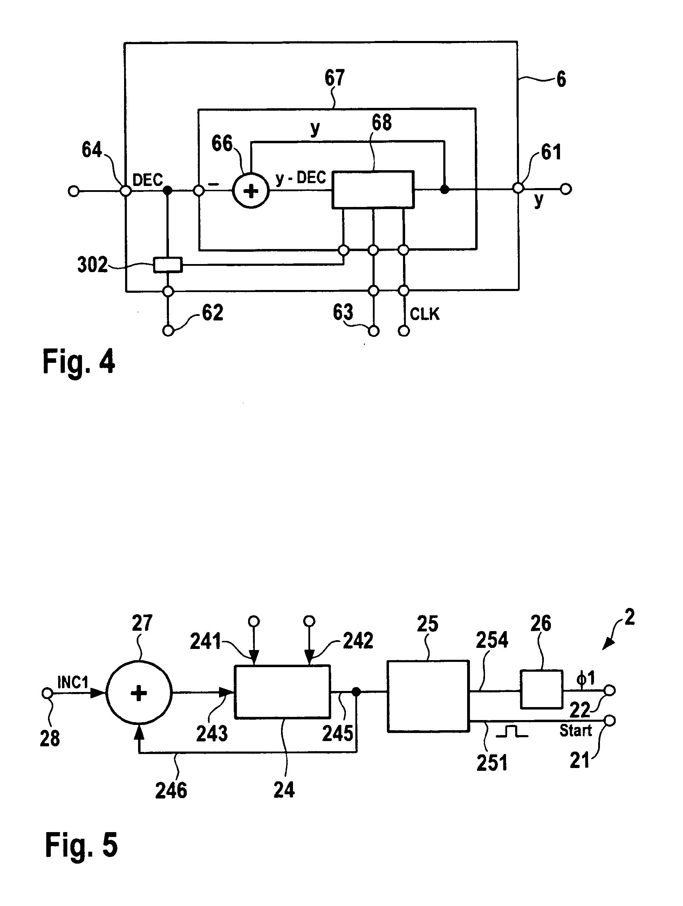

An embodiment of a digital falling edge generator is shown in Figure 4. The digital falling edge generator is similar to the rising edge generator of Figure 3 and Figure 3a. It also comprises a counter 67 having a register 68 of a specific bit length. An input terminal of the register 68 is coupled to a sum element 66, subtracting the decrement word DEC from the output value Y of the register 68. Additionally, the falling edge generator 6 comprises a calculation unit 302, whose two inputs are coupled to the terminals 62 and 64. The calculation unit 302 is adapted for calculating a second offset value defining the starting position of the counter 67.

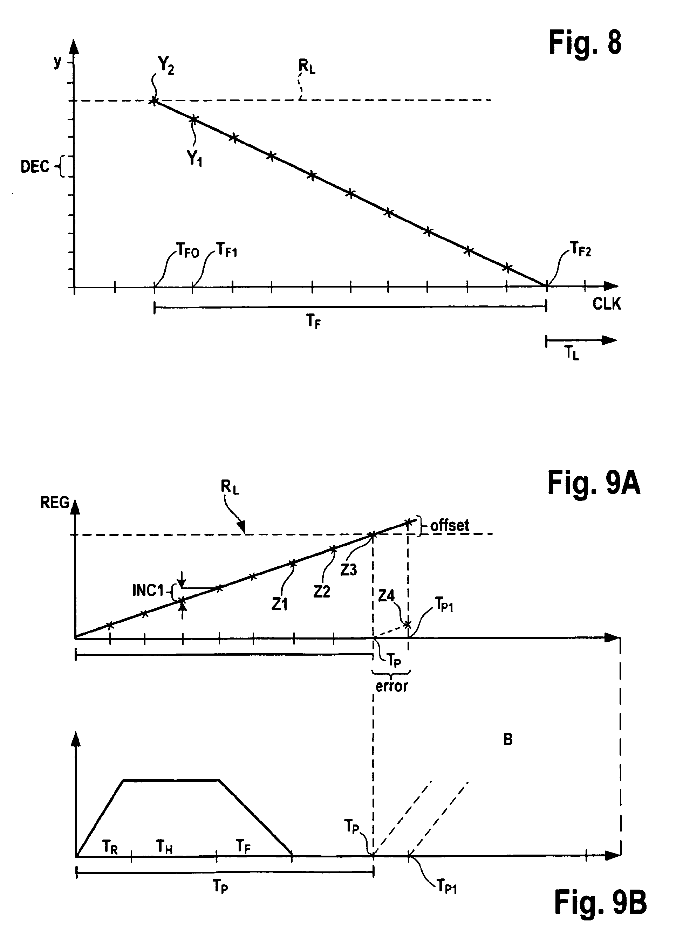

A diagram showing the output Y of the falling edge generator over time in respect to the reference clock cycle can be seen in Figure 8. The maximum value of the register 68 is determined by the register length $R_L$. In this example the falling time is an integer multiple of the reference clock cycle, so no offset has to be calculated. At the time $T_{F0}$, a stop signal is received. The starting position will now be the maximum value, the first output $Y_0$ of the digital falling edge generator at the time $T_{F0}$ will be $R_L$. At the time $T_{F1}$ the falling edge generator 6 has decrement the value $R_L$ by DEC. The counter's values are then decrement and output in respect to the reference clock cycle. At the time $T_{F2}$, the low state of the pulse signal is reached.

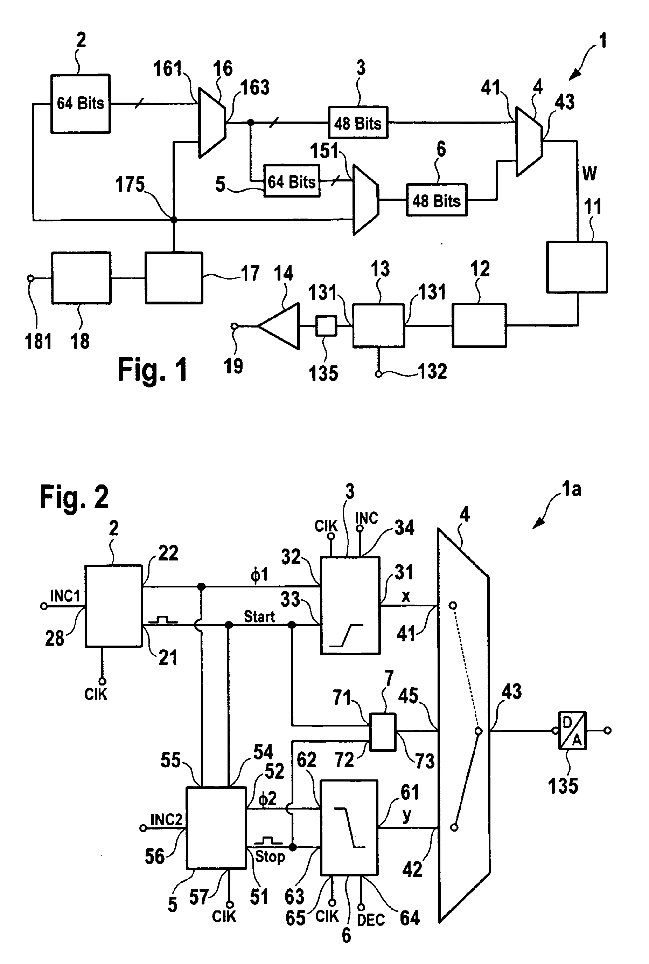

Figure 2 shows the main elements of a fully digital pulse pattern generator according to the present invention. A pulse period counter 2 is adapted for the generation of the pulse period $T_P$. It comprises an input terminal 28 for feeding the increment word INC1. The increment word INC1 corresponds to the time period $T_P$. The pulse period counter device 2 is adapted for the generation of a start signal corresponding to the time period $T_P$ by processing the increment word INC1. A more detailed Figure for period counter device 2 can be seen in Figure 5.

The period counter device 2 comprises a register 24 with an input terminal 243 and an output terminal 245. The output is connected to a feedback path 246 coupled to a summing element 27. The element 27 sums the result of the register 24 and the increment word INC1 and feeds the result to the input 243 of the register 24 as a new input value. The register 24 has additional input terminals 241 and 242 for a reset signal and a start signal. The output terminal of register 245 is connected to an overflow detection and overflow counter 25 for generation of the start signal.

In operation, the period counter 2 outputs a start signal at the output terminal 21. The time period between two start signals corresponds to the time period $T_P$ which is given by the length of the register 24, the reference clock CLK and the increment word INC1. However the increment word, and the pulse period $T_P$ might be a non-integer multiply of the reference clock cycle.

As an non-limiting example, the register length of the period width counter device 2 is 32 bits, the high-stable reference clock CLK comprises a frequency of $2^{29}$ Hz corresponding to a period of the reference clock of $1 / 2^{29}$ s. Let's assume the desired time period $T_P$ shall be 125 ms. This will result in an increment word INC1 of 64. In other words, each reference clock cycle the register's value is incremented by 64. As soon as the register's value reaches its maximum value, which is $2^{32}$ defined by the register length, an overflow will occur, which is detected by the overflow detection circuit 25 according to Figure 5. A start signal is then transmitted at the output terminal 21 and the register is filled again. Due to the fact that the time period of 125 ms or 8 Hz is an integer multiply of $2^{29}$ Hz, no offset is generated.

However, if the pulse period $T_P$ chosen is not an integer multiple of the reference clock cycle, a register overflow will occur. The new register's value will not be zero.

Such behavior can be seen in Figure 9 A (upper diagram), showing a diagram of the register 24 values of the period counter 2 over time. The register's value is incremented by the increment word INC1 each reference clock cycle. For example, after seven reference clock cycles, the register holds the value Z2. After eight reference clock cycles, the register holds the value Z3, which is slightly smaller than the register length RL. The next increment of the register's value will result in an overflow value Z4 of the register 24.

If such overflow is not taken into account, the next pulse will start at the time point $T_{P1}$ and not at the desired time point $T_P$. Such behavior generates a phase offset, resulting in a time period error, which can be seen in the Figure 9 B (lower diagram) below. It shows an exemplary pulse of the time period $T_P$, having a rising edge $T_R$, a high-state time $T_H$ and a falling edge with the time $T_F$. After a further low-state time $T_L$, the pulse signal shall be repeated again at the time point $T_P$. However, due to the error in the register of the period counter, the starting point of the pulse is delayed by some offset given by the register overflow.

Therefore, the overflow detection device 25 according to Figure 5 comprises not only an overflow detection circuit but also an overflow counter capable of determining the overflow value of the register 24. The offset value is output at the output terminal 254 and set into a scaling unit 26. The output of the scaling unit 26 is connected to the output 22 of the period counter. The output terminal 22 of the period counter device 2 provides the first offset word $\phi 1$ representing a phase offset between the increment word INC1, corresponding to the time period and the global reference clock CLK.

In other words, the period counter device comprises a regenerative register, which adds the increment word INC to the register's value every reference clock cycle CLK. After an overflow, the register holds a new value from 0 to the increment word INC -1. The new value represents the phase offset with respect to the reference clock CLK or a delay time, which has to be taken into account, when generating the width and edges of the pulse. It is taken by the overflow detection and overflow counter circuit, which generates a start signal at the output terminal 21 and an offset word φ1 at the output 22. The overflow detection circuit and overflow counter device 25 enable an additional delay for starting the rising edge of the pulse signals.

The start signal as well as the first offset word φ1 is then fed into a digitally rising edge generator 3 according to the present invention.

For setting the pulse width determined by the rising time and the time of the high state, the digitally pulse pattern generator 1 comprises a further width counter 5, which is coupled to the outputs 21 and 22 of the period counter 2. It comprises a further input terminal 56 for an increment word INC2 corresponding to the pulse width $T_W$. An exemplary embodiment of the width counter 5 is seen in Figure 6. The width counter 5 comprises similar to the period counter a register 500 having an output, which is connected to an overflow detection and overflow counter circuitry 501. The output of the register 500 is fed back into a summing element 502, which sums the output of the register 500 and the increment word INC2. The results replace the register's value again.

The width counter device 5 has a similar function to the period counter device 2 except that it will receive its start signal from the input terminal 54 connected to the output terminal 21 of the period counter 2. Additionally, the width counter 58 comprises a calculation unit 58 which takes into account the first offset word φ1 and the increment word INC2 to calculate an offset position to be stored in the register 500 upon detection of a start signal. The offset value stored in the register 500 corresponds to the delay between the starting point of the rising edge of the pulse in respect to the reference clock cycle. The register's length and the incremental word INC2 correspond to the total pulse width $T_W$. As soon as an overflow of the register 500 is detected by the detection unit 501, a stop signal is generated at the output terminal 51. The register 500 also holds an overflow value, which is taken by the overflow detection and overflow counter unit 501 and output at the output terminal 50 as a second offset word φ2.

The outputs of the width counter device 5 are then fed into a falling edge generator 6 as previously described in Figure 4.

Additionally, the digital pulse pattern generator 1 according to Figure 2 comprises a switching unit 4 with two input terminals 41 and 42. The input terminal 41 is connected to the output terminal 31 of the rising edge generator 3. The second input terminal 42 of the switching unit 4 is connected to the output terminal 61 of the falling edge generator 6. The switching unit 4 comprises an output terminal 43 coupled to a digital-analog converter 135. The switching unit 4 is adapted to switch one of its corresponding inputs to its output terminal 33. It comprises a setting terminal 45 connected to a data output 73 of a control unit 7. The control unit 7 comprises two input terminals 71 and 72.

The input terminal 71 is connected to the output terminal 21 of the period counter 2 for the start signal. The second input terminal 72 is connected to the output terminal 51 of the width counter device 5. Depending on the state of the start and the stop signal on the corresponding input terminals 71 and 72, the control unit 7 outputs a signal thereby switching the unit 4. More particularly, if a start signal is present at the input terminal 71, the control unit 7 switches the switching unit 4 to the first state coupling the input terminal 41 to the output terminal 43. As soon as the stop signal is present, corresponding to the start of the falling edge, the control unit 7 sets the switching unit 4 to the second state, thereby coupling the input 42 to the output 43.

The control unit 7 can be adapted as a flip flop with a data input corresponding to the first input terminal 71 and a reset input corresponding to the second input terminal 72. When a start signal is present, a high state is output on the data output of the flip flop as long as the flip flop is not reset by the stop signal provided by the width counter device 5.

Figure 1 shows a further embodiment of the pulse pattern generator 1 according to the present invention. In this embodiment, the period counter device 2 is connected to a first input terminal 161 of the first switching unit 16. The second input terminal 162 of the switching unit 16 is coupled to a trigger calculation unit 17 for feeding an external start trigger. Also, an external clock or an external rising edge can be fed into the digital pulse pattern generator by the input terminal 162 of the switching unit 16.

The output terminal of the switching unit 16 is connected to the input terminals of the rising edge generator 3 and the width counter device 5. The falling edge generator 6 is connected with its input to a second switching device 15. The second switching device 15 also comprises two input terminals 151 and 152. The input terminal 151 is connected to the output of the width counter device 5. The second input terminal 152 is connected to the trigger calculation unit 17. It is adapted for feeding an external clock falling edge signal into the falling edge generator 6.

Using the two additional switches 16 and 15 allows a more flexible digital pulse pattern generation using external triggers, external clocks, or external rising and falling edges.

An input of the trigger calculation unit 17 is connected to a fast analog-digital converter 18 for conversion of an analog trigger signal at the input terminal 181 of the digital pulse pattern generator 1. The digital trigger signal provided by the fast analog-digital converter 18 is processed by the trigger calculation unit 17. Any delay between a trigger start signal at the input 181 and the high-speed reference clock of the digital pulse pattern generator 1 is taken into account and compensated for the later generation of the pulse signals. In other words, the trigger calculation unit compensates any phase delay between the trigger pulse and the reference clock and further compensate the processing time for trigger pulse.

The output terminal of the switching unit 4 is connected to a memory lookup table 11. The output values W generated by the digital pulse pattern generator are used as an argument for the memory lookup table. The memory lookup table 11 is adapted for storing corresponding values to the phase control words W. They can be used to distort the pulse pattern. The output of the memory lookup table 11 is connected to a filter 12 for suppressing undesired signal parts and then used as input for an output calculation or multiply unit 13. The output of unit 13 is connected to a digital-analog converter for the generation of an analog pulse signal. The analog pulse signal might be amplified by an additional amplifier 14 and then fed to the output terminal 19 of the pulse pattern generator 1.

Figure 12 shows an embodiment of the trigger calculation unit 17 and the analog-digital conversion unit 18. In general a trigger signal is used to trigger or activate an action. For pulse pattern generators a trigger can be used to activate the pattern generation and more particular to start the first pulse. It is desirable that the delay between receiving of the trigger and activating the process to be triggered is kept as small as possible. Furthermore it is important, that the delay is kept constant. This directly leads to the problem that for fully digital pattern generation a trigger signal can be in between two subsequent reference clock cycles. The trigger calculation unit 17 along with the preceding elements allows for such cases.

A trigger signal received at the trigger input terminal 181 of figure 12 is compared with a given threshold in the comparator 183. The comparator generates a digital edge, as it can be from the diagram. The output of the comparator 183 is connected to a slope generator 182, which is adapted for transforming the edge from the comparator 183 to a well-defined slope. As one can see from the diagram, near the upper and lower limit the slopes shows a strong nonlinear behavior, while in between it includes a linear ascending gradient. The slope is passed to a fast analog-digital converter 184. The sample frequency for the analog-digital converter 184 might be the reference clock CLK, but can be also higher. It is necessary that the input range of the analog-digital-converter 184 is set to the linear region of the slope generated by the slope generator. Furthermore the slope shall not be faster, than at least two sampling cycles have passed. A minimum of 2 samples has to be taken within analog-digital converter 184 input range. The output of the converter 184 is connected to the calculation unit 17, which calculates an offset. This is performed by calculating an intersection of the sampled straight line with a given constant digital value. For example the digital constant value shall be d0 and two samples of the converter 184 shall be x1/y1 and x2/y2; then the offset $\Phi3$ can be calculated by:

$$\Phi3 = (x1*(y2-d0)-x2*(y1-d0))/(y2-y1)$$

For two subsequent samples x1, x2 the offset $\Phi3$ will be $-y1 / (y2-y1)$. The calculated offset can be used in the period counter device. Using the trigger input the edge generator as well as width counter can be controlled directly. This results in a higher flexibility when generating pulse pattern by an external trigger generator. Furthermore due to the well defined delay between the trigger input and the reference clock of the generator, this concept is usable not only for pulse pattern generation but for every signal generation.

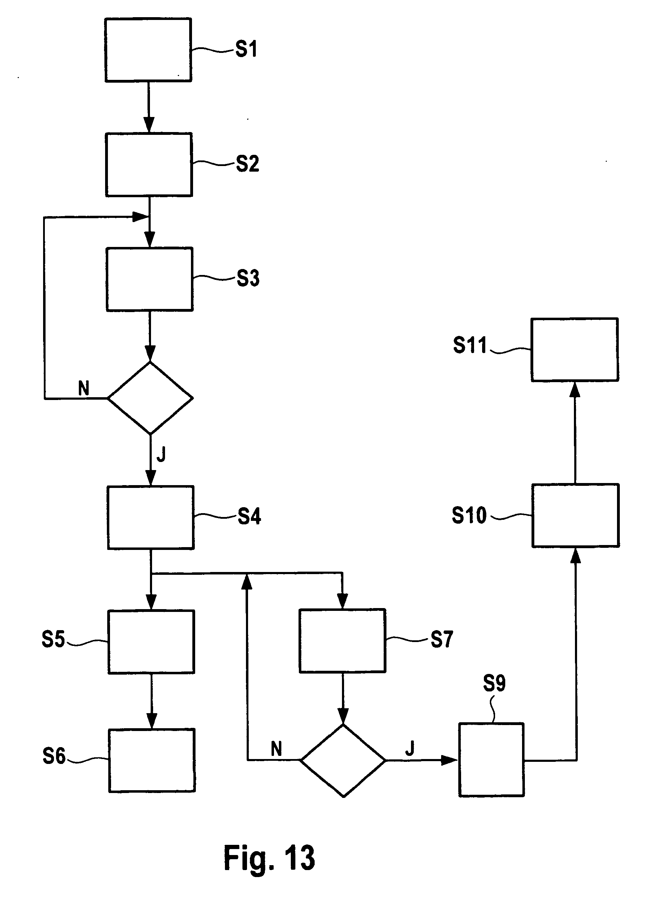

The generation of pulse pattern signals is not limited to hardware components like the pulse pattern generator shown in Figures 1 and 2. The generation of pulse signals comprising a pulse period $T_P$ and a pulse width $T_W$ is possible if all necessary parameters are known and can be derived from a stable high reference clock. Figure 13 shows a diagram of a method for generating pulse signals according to the present invention.

The first step S1 comprises the provision of a stable reference clock. The stable reference clock can be, for example, a clock signal provided by an oscillator of a DSP, a processor clock signal, or an internal signal generated by a computer. Even a software clock derived by internal hardware for data processing systems can be used. The pulse period $T_P$ as well as the pulse width $T_W$ of the desired signal have to be known. They are provided, for example, by receiving a signal representing the pulse period $T_P$.

In the examples according to Figures 1 and 2, those signals are corresponding to the increment words INC1 and INC2. From those words and the lengths of the registers of the period counter 2 and the width counter device 5, the pulse period $T_P$ and the pulse width can be calculated. On the other hand, the increment words INC1 and INC2 can be calculated if the pulse period $T_P$ or a pulse width $T_W$ are given and the respective length of the register or the maximum values of the counters are known. After providing the pulse period and the pulse width, the increment words INC1 and INC2 are calculated in step S2. Using the increment word INC1, corresponding to the pulse period $T_P$, the period counter device increments its counter and detects, whether the counter has produced an overflow in Step S3. If an overflow is not detected, the counter will be incremented with the increment word INC1 again. Step S3 is repeated if an overflow is detected, the offset word $\phi1$ is calculated by the overflow value and a start signal is generated in Step S4.

The start signal will start a rising edge counter in Step S5, which has been set to a starting position derived from the first offset word $\Phi1$. With each reference clock cycle, the position of the rising edge counter is output and the rising edge counter is incremented by the increment word INC provided in step S2. This is done in Step S5 and S6. Of course it has to be mentioned that during the generation of the rising edge, the time period counter is incremented again with its increment word INC1.

The start signal is also used for the generation of the pulse width $T_W$. The offset word generated in step S4 is used in step S7 as a starting position for an additional counter which is incremented by the second increment word INC2. As soon as the second counter produces an overflow, it will be detected and a stop signal is generated in step S9. Furthermore, a second offset word $\phi2$ derived from the overflow value of the second counter in step S7 is generated. A falling edge is produced in step S10 using the stop signal and the second offset word. A falling edge is then output in step S11.

The method steps of incrementing the counters are performed parallel. Hence, the pulse period time and pulse width counter are incremented, while a rising edge is generated and output. It is clear that the digital pulse pattern generated by this method is converted into an analog pulse signal. However, all pulse parameters are generated fully digitally.

**Claims**

1. A signal generator (3, 6) for generating a signal edge with a sequence of digital values spaced according to a reference clock signal (CLK), comprising:

    • at least one input terminal (33, 63, 34, 64, 32, 62) for receiving an increment signal (INC, DEC) and an offset signal ($\Phi1$, $\Phi2$),
    • a start value circuit (302) adapted for determining a counter start value on the base of the offset signal ($\Phi1$, $\Phi2$) and the increment signal (INC, DEC),
    • a counter (37, 67) being adapted to be set to the counter start value, and to change the counter position at each cycle of the reference clock signal (CLK) to a new value according to the increment signal (INC, DEC) until a defined value is achieved, and
    • an output terminal for outputting the counter values.

2. The signal generator of claim 1, further adapted for receiving a start signal and to be set to the counter start value upon detection of the start signal.

3. The signal generator of claim 1 or any one of the above claims, comprising a first input terminal (33, 63) adapted for receiving a start signal, a second terminal (34, 64) for receiving the increment signal (INC, DEC) and a third input terminal (32, 62) for receiving the offset signal ($\Phi1$, $\Phi2$).

4. The signal generator of claim 1 or any one of the above claims, wherein the counter (37, 67) comprises a register (38, 68) and a summing element (36, 66), the summing element (36, 66) being connected to the first input terminal (33, 63) and an output of the register (38, 68).

5. The signal generator of claim 1 or any one of the above claims, wherein the counter (37) comprises a switch (300) coupled with its output to the register (37), with its first input to the output to the summing element (36) and with its second input to the second input terminal.

6. The signal generator of claim 5 or any one of the above claims, further comprising:

    a setting device (302) connected to the second input terminal (34, 64), the third input (32, 62) terminal and the second input of the switch (300), the setting device (302) being adapted for generating the start position out of the offset signal ($\Phi1$) in reference to the increment signal (INC).

7. The signal generator of claim 1 or any one of the above claims, wherein the output of the counter (37, 67) is coupled to a memory lookup table (11), the memory lookup table (11) adapted for generating digital values derived from the output of the counter (37, 67).

8. The signal generator of claim 1 or any one of the above claims, wherein the output of the counter (37, 67) is coupled to a first input of a switch (301), whose second input being adapted for feeding a constant digital value, wherein the switch (301) switches upon detection of the start signal and dependant from the counter's position.

9. The signal generator of claim 1 or any one of the above claims, wherein the increment signal (INC, DEC) comprises a negative value.

10. A digital pulse signal generator (1) for generating pulse signals with a first and a second signal generator of claim 1 or any one of the above claims and further comprising:

    • a period counter (2), adapted for generating the start signal (Start) and a first offset signal ($\Phi_1$), the start signal (Start) derived from a reference clock (CLK) and a given pulse period ($T_p$), the first offset signal ($\Phi_1$) derived from the reference clock (CLK) and the given pulse width, the period counter (2) connected with it's outputs to the respective inputs of the first digital edge generator (3), and

• a width counter (5), coupled to the period counter (2) and adapted for generating a stop signal (Stop) and a second offset signal ($\Phi_2$) derived from a given pulse width ($T_w$), the reference clock (CLK) and the first offset signal ($\Phi_1$) in respect to the start signal (Start), the width counter connected with its outputs to the respective inputs of the a second digital edge generator (6).

11. The pulse generator of claim 10 or any one of the above claims, further comprising a switching device (4) coupled with inputs (41, 42) to respective outputs (31,61) of the respective first (3) and second edge generator (6), the switching device (4) being adapted for switching one of its inputs (41, 42) to its output (43) in respective to the start signal (Start) and the stop signal (Stop).

12. The pulse generator of claim 10 or any one of the above claims, wherein the switching unit (4) is adapted for coupling the output (31) of the first edge generator (31) to its output (43) in case a start signal (Start) is present and for coupling the output (61) of the second edge generator (6) to its output (43) in case a stop signal (Stop) is present.

13. The pulse generator of claim 10 or any one of the above claims, wherein the period counter (2) comprises a first register (24), a overflow detection device (25) coupled to the first register (24) and being adapted for detecting an overflow of the first register (24), the period counter (2) adapted for generating the start signal (Start) in respect to the overflow detection and for generating the first offset signal ($\Phi_1$) derived from an overflow value of the first register (24).

14. The pulse generator of claim 13 or any one of the above claims, wherein the pulse period ($T_p$) is derived from a length of the first register (24) and an incremental signal (INC1).

15. The pulse generator of claim 10 or any one of the above claims, wherein the width counter (5) comprises a second register (500), a overflow detection device (501) coupled to the second register (500) and being adapted for detecting an overflow of the second register (500), the width counter (5) adapted for generating a stop signal (Stop) in respect to the overflow detection and for generating the second offset signal ($\Phi_2$) derived from an overflow value of the second register (500).

16. The pulse generator of claim 10 or any one of the above claims, wherein the pulse generator (1) comprises a memory table (11), coupled to outputs (31, 61) of the first and second edge generators (3, 6), the memory table (5) adapted for generating digital values derived from the output values of the first and second edge generators (3, 6).

17. The signal generator of claim 2 or any one of the above claims, further comprising a trigger calculation unit (17) adapted for receiving a trigger signal determining the offset signal ($\Phi3$) corresponding to a delay between the trigger signal and the reference clock.

18. The signal generator of claim 17, wherein an input of the trigger calculation unit is coupled to a slope generator adapted for transforming a trigger signal into a defined slope having a linear ascending region.

19. A method for generating a sequence of digital values spaced according to a reference clock signal (CLK), comprising the steps of:

• receiving an increment signal (INC, DEC) and an offset signal ($\Phi1$, $\Phi2$),
• determining a counter start value on the base of the offset signal ($\Phi1$, $\Phi2$) and the increment signal (INC, DEC),
• setting a counter to the start value, and changing the counter position at each cycle of the reference clock signal (CLK) to a new value according to the increment signal (INC, DEC) until a defined value is achieved, and outputting the counter values.

20. A software program or product, preferably stored on a data carrier, for controlling the steps of claim 19, when running on a data processing system such as a computer.

**Patentansprüche**

1. Signalgenerator (3, 6) zum Erzeugen einer Signalflanke mit einer Folge digitaler Werte, die gemäß einem Referenztaktsignal (CLK) beabstandet sind, wobei der Signalgenerator Folgendes aufweist:

• mindestens einen Eingangsanschluss (33, 63, 34, 64, 32, 62) zum Empfangen eines Schrittsignals (INC, DEC) und eines Versatzsignals ($\Phi_1$, $\Phi_2$),
• eine Startwertschaltung (302) zum Ermitteln des Startwertes eines Zählers auf der Grundlage des Versatzsignals ($\Phi_1$, $\Phi_2$) und des Schrittsignals (INC, DEC),
• einen Zähler (37, 67), der auf den Zählerstartwert eingestellt und dessen Zählerstand während jedes Zyklus des Referenztaktsignals (CLK) so lange entsprechend dem Schrittsignal (INC, DEC) auf einen neuen Wert eingestellt werden kann, bis ein definierter Wert erreicht wird, und
• einen Ausgangsanschluss zum Ausgeben der Zählerwerte.

2. Signalgenerator nach Anspruch 1, der ferner so eingerichtet ist, dass er ein Startsignal empfangen und nach dem Erkennen des Startsignals auf einen Zählerstartwert eingestellt werden kann.

3. Signalgenerator nach Anspruch 1 oder einem der obigen Ansprüche, der einen ersten Eingangsanschluss (33, 63) zum Empfangen eines Startsignals, einen zweiten Anschluss (34, 64) zum Empfangen des Schrittsignals (INC, DEC) und einen dritten Eingangsanschluss (32, 62) zum Empfangen des Versatzsignals ($\Phi_1$, $\Phi_2$) aufweist.

4. Signalgenerator nach Anspruch 1 oder einem der obigen Ansprüche, bei dem der Zähler (37, 67) ein Register (38, 68) und ein Summierelement (36, 66) aufweist, wobei das Summierelement (36, 66) mit dem ersten Eingangsanschluss (33, 63) und einem Ausgang des Registers (38, 68) verbunden ist.

5. Signalgenerator nach Anspruch 1 oder einem der obigen Ansprüche, bei dem der Zähler (37) einen Schalter (300) aufweist, dessen Ausgang mit dem Register (38), dessen erster Eingang mit dem Ausgang des Summierelements (36) und dessen zweiter Eingang mit dem zweiten Eingangsanschluss verbunden ist.

6. Signalgenerator nach Anspruch 5 oder einem der obigen Ansprüche, der ferner Folgendes aufweist:

eine mit dem zweiten Eingangsanschluss (34, 64), dem dritten Eingangsanschluss (32, 62) und dem zweiten Eingang des Schalters (300) verbundene Einstelleinrichtung, wobei die Einstelleinrichtung zum Erzeugen der Startposition aus dem Versatzsignal ($\Phi_1$) in Verbindung mit dem Schrittsignal (INC) eingerichtet ist.

7. Signalgenerator nach Anspruch 1 oder einem der obigen Ansprüche, bei dem der Ausgang des Zählers (37, 67) mit einer Speichersuchtabelle (11) verbunden ist, wobei die Speichersuchtabelle (11) zum Erzeugen digitaler Werte dient, die vom Ausgabewert des Zählers (37, 67) abgeleitet werden.

8. Signalgenerator nach Anspruch 1 oder einem der obigen Ansprüche, bei dem der Ausgabewert des Zählers (37, 67) mit einem ersten Eingang eines Schalters (301) verbunden ist, dessen zweiter Eingang zum Eingeben eines konstanten digitalen Wertes dient, wobei der Schalter (301) nach dem Erkennen des Startsignals und in Abhängigkeit vom Zählerstand umschaltet.

9. Signalgenerator nach Anspruch 1 oder einem der obigen Ansprüche, bei dem das Schrittsignal (INC, DEC) einen negativen Wert aufweist.

10. Digitaler Impulssignalgenerator (1) zum Erzeugen von Impulssignalen mit einem ersten und einem zweiten Signalgenerator nach Anspruch 1 oder einem der obigen Ansprüche, der ferner Folgendes aufweist:

• einen Periodenzähler (2) zum Erzeugen des Startsignals (Start) und eines ersten Versatzsignals ($\Phi_1$), wobei das Startsignal (Start) von einem Referenztakt (CLK) und einer bestimmten Impulsperiode (Tp) und das erste Versatzsignal ($\Phi_1$) vom Referenztakt (CLK) und einer bestimmten Impulsbreite abgeleitet wird und die Ausgänge des Periodenzählers (2) mit den entsprechenden Eingängen des ersten digitalen Flankengenerators (3) verbunden sind, und
• einen mit dem Periodenzähler (2) verbundenen Breitenzähler (5) zum Erzeugen eines Stoppsignals (Stopp) und eines zweiten Versatzsignals ($\Phi_2$), das von einer bestimmten Impulsbreite ($T_w$), dem Referenztakt (CLK) und dem ersten Versatzsignal ($\Phi_1$) in Verbindung mit dem Startsignal (Start) abgeleitet wird, wobei die Ausgänge des Breitenzählers mit den entsprechenden Eingängen eines zweiten digitalen Flankengenerators (6) verbunden sind.

11. Impulsgenerator nach Anspruch 10 oder einem der obigen Ansprüche, der ferner eine Schalteinheit (4) aufweist, deren Eingänge (41, 42) mit entsprechenden Ausgängen (31, 61) des ersten (3) bzw. zweiten Flankengenerators (6) verbunden sind, wobei die Schalteinheit (4) zum Durchschalten eines ihrer Eingänge (41, 42) zu ihrem Ausgang (43) als Reaktion auf das Startsignal (Start) bzw. das Stoppsignal (Stopp) eingerichtet ist.

12. Impulsgenerator nach Anspruch 10 oder einem der obigen Ansprüche, bei dem die Schalteinheit (4) zum Verbinden des Ausgangs (31) des ersten Flankengenerators (3) mit seinem Ausgang (43), wenn ein Startsignal (Start) anliegt, oder zum Verbinden des Ausgangs (61) des zweiten Flankengenerators (6) mit seinem Ausgang (43) eingerichtet ist, wenn ein Stoppsignal anliegt.

13. Impulsgenerator nach Anspruch 10 oder einem der obigen Ansprüche, bei dem der Periodenzähler (2) ein erstes Register (24) und eine mit dem ersten Register (24) verbundene Überlauferkennungseinheit (25) zum Erkennen eines Überlaufs des ersten Registers (24) aufweist, wobei der Periodenzähler (2) zum Erzeugen des Startsignals (Start) als Reaktion auf das Erkennen eines Überlaufs und zum Erzeu-

gen des ersten Versatzsignals ($\Phi_1$) eingerichtet ist, das von einem Überlaufwert des ersten Registers (24) abgeleitet wird.

14. Impulsgenerator nach Anspruch 13 oder einem der obigen Ansprüche, bei dem die Impulsperiode (Tp) von einer Länge des ersten Registers (24) und einem Schrittsignal ($INC_1$) abgeleitet wird.

15. Impulsgenerator nach Anspruch 10 oder einem der obigen Ansprüche, bei dem der Breitenzähler (5) ein zweites Register (500) und eine mit dem zweiten Register (500) verbundene Überlauferkennungseinheit (501) zum Erkennen eines Überlaufs des zweiten Registers (500) aufweist, wobei der Breitenzähler (5) zum Erzeugen eines Stoppsignals als Reaktion auf das Erkennen eines Überlaufs und zum Erzeugen des zweiten Versatzsignals ($\Phi_2$) eingerichtet ist, das von einem Überlaufwert des zweiten Registers (500) abgeleitet wird.

16. Impulsgenerator nach Anspruch 10 oder einem der obigen Ansprüche, wobei der Impulsgenerator (1) eine mit den Ausgängen (31, 61) des ersten und des zweiten Flankengenerators (3, 6) verbundene Speichertabelle (11) aufweist, wobei die Speichertabelle (11) zum Erzeugen von digitalen Werten eingerichtet ist, die von den Ausgabewerten des ersten und des zweiten Flankengenerators (3, 6) abgeleitet werden.

17. Signalgenerator nach Anspruch 2 oder einem der obigen Ansprüche, der ferner eine Auslöseberechnungseinheit (17) zum Empfangen eines Auslösesignals eingerichtet ist, um das einer Verzögerung zwischen dem Auslösesignal und dem Referenztakt entsprechende Versatzsignal ($\Phi_3$) zu ermitteln.

18. Signalgenerator nach Anspruch 17, bei dem ein Eingang der Auslöseberechnungseinheit mit einem Rampengenerator verbunden ist, der zum Umwandeln eines Auslösesignals in einen definierten Flankenanstieg mit einem linear ansteigenden Bereich dient.

19. Verfahren zum Erzeugen einer Folge digitaler Werte in einem durch ein Referenztaktsignal (CLK) festgelegten Abstand voneinander, wobei das Verfahren die folgenden Schritte aufweist:

  • Empfangen eines Schrittsignals (INC, DEC) und eines Versatzsignals ($\Phi_1$, $\Phi_2$),
  • Ermitteln eines Zählerstartwertes auf der Grundlage des Versatzsignals ($\Phi_1$, $\Phi_2$) und des Schrittsignals (INC, DEC),
  • Einstellen eines Zählers auf den Startwert und Ändern des Zählerstandes während jedes Zyklus des Referenztaktsignals (CLK) auf einen neuen Wert in Abhängigkeit vom Schrittsignal (INC, DEC), bis ein definierter Wert erreicht ist, und
  • Ausgeben der Zählerwerte.

20. Softwareprogramm oder Softwareprodukt, das vorzugsweise auf einem Datenträger gespeichert ist, zum Steuern der Schritte von Anspruch 19, wenn es auf einem Datenverarbeitungssystem wie beispielsweise einem Computer läuft.

## Revendications

1. Générateur de signaux (3, 6) pour générer un flanc de signal avec une suite de valeurs numériques espacées en fonction d'un signal d'horloge de référence (CLK), comprenant :

  • au moins une borne d'entrée (33, 63, 34, 64, 32, 62) pour recevoir un signal d'incrémentation (INC, DEC) et un signal de décalage ($\phi1$, $\phi2$);
  • un circuit de valeur de départ (302) à même de déterminer une valeur de départ de compteur sur la base du signal de décalage ($\phi1$, $\phi2$) et du signal d'incrémentation (INC, DEC) ;
  • un compteur (37, 67) à même d'être réglé sur la valeur de départ de compteur, et de modifier la position du compteur à chaque cycle du signal d'horloge de référence (CLK) sur une nouvelle valeur en fonction du signal d'incrémentation (INC, DEC) jusqu'à ce qu'une valeur définie soit obtenue, et
  • une borne de sortie pour fournir en sortie les valeurs de compteur.

2. Générateur de signaux suivant la revendication 1, en outre à même de recevoir un signal de départ et d'être réglé sur la valeur de départ de compteur lors de la détection du signal de départ.

3. Générateur de signaux suivant la revendication 1 ou suivant l'une quelconque des revendications précédentes, comprenant une première borne d'entrée (33, 63) à même de recevoir un signal de départ, une deuxième borne d'entrée (34, 64) pour recevoir le signal d'incrémentation (INC, DEC) et une troisième borne d'entrée (32, 62) pour recevoir le signal de décalage ($\phi1$, $\phi2$).

4. Générateur de signaux suivant la revendication 1 ou suivant l'une quelconque des revendications précédentes, dans lequel le compteur (37, 67) comprend un registre (38, 68) et un élément de sommation (36, 66), l'élément de sommation (36, 66) étant connecté à la première borne d'entrée (33, 63) et à une sortie du registre (38, 68).

5. Générateur de signaux suivant la revendication 1 ou suivant l'une quelconque des revendications précédentes, dans lequel le compteur (37) comprend un commutateur (300) connecté par sa sortie au registre (37), par sa première entrée à la sortie de l'élément de sommation (36) et par sa deuxième entrée à la deuxième borne d'entrée.

**6.** Générateur de signaux suivant la revendication 5 ou suivant l'une quelconque des revendications précédentes, comprenant en outre :

un dispositif de réglage (302) connecté à la deuxième borne d'entrée (34, 64), la troisième borne d'entrée (32, 62) et la deuxième entrée du commutateur (300), le dispositif de réglage (302) étant à même de générer la position de départ à partir du signal de décalage ($\phi$1) en référence au signal d'incrémentation (INC).

**7.** Générateur de signaux suivant la revendication 1 ou suivant l'une quelconque des revendications précédentes, dans lequel la sortie du compteur (37, 67) est connectée à une table à consulter de mémoire (11), la table à consulter de mémoire (11) étant à même de générer des valeurs numériques dérivées de la sortie du compteur (37, 67).

**8.** Générateur de signaux suivant la revendication 1 ou suivant l'une quelconque des revendications précédentes, dans lequel la sortie du compteur (37, 67) est connectée à une première entrée d'un commutateur (301), dont la deuxième entrée est à même d'appliquer une valeur numérique constante, dans lequel le commutateur (301) commute lors de la détection du signal de départ et en fonction de la position du compteur.

**9.** Générateur de signaux suivant la revendication 1 ou suivant l'une quelconque des revendications précédentes, dans lequel le signal d'incrémentation (INC, DEC) comprend une valeur négative.

**10.** Générateur de signaux d'impulsion numériques (1) pour générer des signaux d'impulsion avec un premier générateur de signaux et un deuxième générateur de signaux suivant la revendication 1 ou suivant l'une quelconque des revendications précédentes et comprenant en outre :

• un compteur de période (2), à même de générer le signal de départ (Start) et un premier signal de décalage ($\Phi_1$), le signal de départ (Start) étant dérivé d'un signal d'horloge de référence (CLK) et d'une période d'impulsion donnée ($T_p$), le premier signal de décalage ($\Phi_1$) étant dérivé du signal d'horloge de référence (CLK) et de la largeur d'impulsion donnée, le compteur de période (2) étant connecté par ses sorties aux entrées respectives du premier générateur de flanc numérique (3), et
• un compteur de largeur (5), connecté au compteur de période (2) et à même de générer un signal d'arrêt (Stop) et un deuxième signal de décalage ($\Phi_2$) dérivé d'une largeur d'impulsion donnée ($T_W$), du signal d'horloge de référence (CLK) et du premier signal de décalage ($\Phi_1$) par rapport au signal de départ (Start), le compteur de largeur étant connecté par ses sorties aux entrées respectives du deuxième générateur de flanc numérique (6).

**11.** Générateur d'impulsions suivant la revendication 10 ou suivant l'une quelconque des revendications précédentes, comprenant en outre un dispositif de commutation (4) connecté par ses entrées (41, 42) à des sorties respectives (31, 61) du premier (3) et du deuxième (6) générateurs de flanc respectifs, le dispositif de commutation (4) étant à même de commuter une de ses entrées (41, 42) vers sa sortie (43) en fonction du signal de départ (Start) et du signal d'arrêt (Stop) respectifs.

**12.** Générateur d'impulsions suivant la revendication 10 ou suivant l'une quelconque des revendications précédentes, dans lequel l'unité de commutation (4) est à même de connecter la sortie (31) du premier générateur de flanc (31) à sa sortie (43) en cas de présence d'un signal de départ (Start) et de connecter la sortie (61) du deuxième générateur de flanc (6) à sa sortie (43) en cas de présence d'un signal d'arrêt (Stop).

**13.** Générateur d'impulsions suivant la revendication 10 ou suivant l'une quelconque des revendications précédentes, dans lequel le compteur de période (2) comprend un premier registre (24), un dispositif de détection de dépassement de capacité (25) connecté au premier registre (24) et étant à même de détecter un dépassement de capacité du premier registre (24), le compteur de période (2) étant à même de générer le signal de départ (Start) par rapport à la détection d'un dépassement de capacité et de générer le premier signal de décalage ($\Phi_1$) dérivé d'une valeur de dépassement de capacité du premier registre (24).

**14.** Générateur d'impulsions suivant la revendication 13 ou suivant l'une quelconque des revendications précédentes, dans lequel la période d'impulsion (Tp) est dérivée d'une longueur du premier registre (24) et d'un signal incrémentiel (INC1).

**15.** Générateur d'impulsions suivant la revendication 10 ou suivant l'une quelconque des revendications précédentes, dans lequel le compteur de largeur (5) comprend un deuxième registre (500), un dispositif de détection de dépassement de capacité (501) connecté au deuxième registre (500) et à même de détecter un dépassement de capacité du deuxième registre (500), le compteur de largeur (5) étant à même de générer un signal d'arrêt (Stop) par rapport à la détection d'un dépassement de capacité et de générer le deuxième signal de décalage ($\Phi_2$) dérivé d'une valeur de dépassement de capacité du deuxième registre (500).

16. Générateur d'impulsions suivant la revendication 10 ou suivant l'une quelconque des revendications précédentes, dans lequel le générateur d'impulsions (1) comprend une table de mémoire (11), connectée aux sorties (31, 61) du premier générateur de flanc et du deuxième générateur de flanc (3, 6), la table de mémoire (5) étant à même de générer des valeurs numériques dérivées des valeurs de sortie du premier et du deuxième générateurs de flanc (3, 6).

17. Générateur de signaux suivant la revendication 2 ou suivant l'une quelconque des revendications précédentes, comprenant en outre une unité de calcul de déclenchement (17) à même de recevoir un signal de déclenchement déterminant le signal de décalage ($\Phi_3$) correspondant à un retard entre le signal de déclenchement et le signal d'horloge de référence.

18. Générateur de signaux suivant la revendication 17, dans lequel une entrée de l'unité de calcul de déclenchement est connectée à un générateur de pente à même de transformer un signal de déclenchement en une pente définie présentant une zone de croissance linéaire.

19. Procédé permettant de générer une suite de valeurs numériques espacées en fonction d'un signal d'horloge de référence (CLK), comprenant les étapes suivantes :

   • la réception d'un signal d'incrémentation (INC, DEC) et d'un signal de décalage ($\phi1$, $\phi2$) ;
   • la détermination d'une valeur de début de compteur sur la base du signal de décalage ($\phi1$, $\phi2$) et du signal d'incrémentation (INC, DEC) ;
   • le réglage d'un compteur sur la valeur de départ, et la modification de la position du compteur à chaque cycle du signal d'horloge de référence (CLK) sur une nouvelle valeur en fonction du signal d'incrémentation (INC, DEC) jusqu'à ce qu'une valeur définie soit obtenue, et
   • la fourniture en sortie des valeurs de compteur.

20. Programme ou produit logiciel, de préférence stocké sur un support de données, pour commander les étapes de la revendication 19, lors de son exécution sur un système de traitement de données tel qu'un ordinateur.

**Fig. 1**

**Fig. 2**

## Fig. 3

## Fig. 3A

**Fig. 4**

**Fig. 5**

**Fig. 6**

**Fig. 7**

**Fig. 8**

**Fig. 9A**

**Fig. 9B**

Fig. 10

Fig. 11

Fig. 12

**Fig. 13**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0875994 A